**Europäisches Patentamt**

**European Patent Office**

**Office européen des brevets**

(11) Veröffentlichungsnummer: **0 135 665 B1**

# (12) EUROPÄISCHE PATENTSCHRIFT

(45) Veröffentlichungstag der Patentschrift: **03.07.91**

(51) Int. Cl.⁵: **H01L 41/04**

(21) Anmeldenummer: **84105370.5**

(22) Anmeldetag: **11.05.84**

(54) **Wandlerplatte für piezoelektrische Wandler und Vorrichtung zu deren Herstellung.**

(30) Priorität: **29.09.83 DE 3335431**

(43) Veröffentlichungstag der Anmeldung:
**03.04.85 Patentblatt 85/14**

(45) Bekanntmachung des Hinweises auf die
Patenterteilung:
**03.07.91 Patentblatt 91/27**

(84) Benannte Vertragsstaaten:
**AT BE CH FR GB IT LI NL SE**

(56) Entgegenhaltungen:
**EP-A- 0 069 824**
**DE-A- 3 309 851**
**US-A- 4 475 014**

(73) Patentinhaber: **Siemens Aktiengesellschaft**
**Wittelsbacherplatz 2**
**W-8000 München 2(DE)**

(72) Erfinder: **Edinger, Egon**
**Buchenstrasse 3**
**W-8033 Krailling(DE)**
Erfinder: **Schade, Reinhart**
**Mozartstrasse 11g**
**W-8037 Olching(DE)**

## Beschreibung

Die Erfindung betrifft eine Wandlerplatte für piezoelektrische Wandler nach dem Oberbegriff des Anspruchs 1, sowie Vorrichtungen zur Herstellung einer derartigen Wandlerplatte.

Wandlerplatten für piezoelektrische Wandler, insbesondere Fernhörer in Fernsprechanlagen, sind in der Regel in ihrem Randbereich zwischen Lagerkörpern eingespannt gehalten und mit einer beidseitig mit Elektroden versehenen Piezokeramik verbunden, wobei die elektrische Zuführung an die Elektroden der Piezokeramik über Anschlußbändchen oder dgl. herstellbar ist.

Derartige Wandlerplatten sind aus einer Vielzahl von Veröffentlichungen bekannt. In diesem Zusammenhang wird auf die DE-OS 31 07 344 und die DE-OS 31 07 293 verwiesen, bei welchen ebenfalls die Wandlerplatte in ihrem Randbereich zwischen Lagerkörpern eingespannt gehalten ist.

Die Verbindung zwischen einer Wandlerplatte aus elektrisch leitfähigem Material und der beidseitig mit Elektroden versehenen Piezokeramik kann mittels einer elektrisch isolierenden Klebeschicht unter Wärme- und Druckeinwirkung erfolgen. Aus der DE-OS 28 20 403 ist es bekannt, hierbei die innere, klebstoffseitige Elektrode der Piezokeramik durch ein Anschlußbändchen zu kontaktieren, welches etwas dünner als die Klebeschicht ist und vor dem Aufbringen der Piezokeramik auf die Klebeschicht aufgelegt wird.

Piezoelektrische Wandler gehören zur Gruppe der reversiblen Wandler, d.h. sie können elektrisch angeregt werden und geben dann Schall ab oder umgekehrt. Diese Wandler sind demnach vielseitig einsetzbar. So können sie in Sprechkapseln, Hörkapseln oder als Tonruf bei Fernsprechanlagen Verwendung finden. Je nach seiner Anwendung muß der Wandler speziell an die Erfordernisse beispielsweise einer Hörkapsel angepaßt werden, d.h. es ist unter Umständen ein Verstärker vorzusehen, oder es müssen die Resonatorräume sowie Schallführungskanäle speziell auf den jeweiligen Einsatz abgestimmt werden.

Bei der Verwendung piezoelektrischer Wandler als Fernhörer ist eine Wandlerkapazität von etwa 200 nF erforderlich, um den erforderlichen Spannungs-Übertragungsfaktor im Fernsprecher zu erreichen, da damit der Fernhörer an den Fernsprecher angepaßt ist. Zur Realisierung sind zwei Lösungen bekannt geworden. Die eine Lösung besteht in der Verwendung einer sehr dünnen Keramik mit einer mittleren Dielektrizitätskonstanten von $\epsilon = 1500$, die andere in der Verwendung einer mittleren Keramikdicke von ca. 100 $\mu$m mit einer höheren Dielektrizitätskonstanten von $\epsilon = 4000$. Die zuerst genannte Lösung kann zu Problemen bei der automatischen Verklebung der dünnen Keramik führen. Die zweite Lösung erfordert eine hohe Dielektrizitätskonstante, die eine höhere Temperaturabhängigkeit der Keramik zur Folge hat.

Um nun die Temperaturabhängigkeit der Wandlerplatte vernachlässigbar klein zu halten, ohne daß eine allzu dünne Keramik Verwendung finden müßte, wurde von der Anmelderin bereits firmenintern vorgeschlagen, daß auf beide Seiten der Wandlerplatte jeweils eine beidseitig mit Elektroden versehene Piezokeramik aufgebracht wird und beide Piezokeramiken elektrisch parallel geschaltet werden.

Der Erfindung liegt die Aufgabe zugrunde, bei einer Wandlerplatte mit auf beide Seiten aufgebrachten Piezokeramiken die beiden inneren Elektroden sicher und mit möglichst geringem Aufwand zu kontaktieren.

Diese Aufgabe wird bei einer Wandlerplatte der eingangs genannten Art durch die kennzeichnenden Merkmale des Anspruchs 1 gelöst. Die mit der Erfindung erzielten Vorteile bestehen insbesondere darin, daß die beiden inneren Elektroden mit Hilfe eines einzigen Anschlußbändchens kontaktiert werden können und somit ein viertes Anschlußbändchen entfallen kann.

Bei einer bevorzugten Ausgestaltung der erfindungsgemäßen Wandlerplatte ist vorgesehen, daß die beiden beidseitig mit Elektroden versehenen Piezokeramiken einander gegenüberliegend auf der Wandlerplatte angeordnet sind und daß der Durchbruch im Bereich der Piezokeramiken in die Wandlerplatte eingebracht ist. Hierbei ergibt sich eine besonders zweckmäßige symmetrische Anordnung der beiden Piezokeramiken.

Bei einer weiteren bevorzugten Ausgestaltung der erfindungsgemäßen Wandlerplatte ist das Anschlußbändchen auf der dem Stanzgrad gegenüberliegenden Seite der Wandlerplatte nach außen geführt. Ein Kurzschluß zwischen dem Anschlußbändchen und dem herstellungsbedingten Stanzgrat der Wandlerplatte kann dann mit Sicherheit ausgeschlossen werden.

Die Erfindung gibt ferner vorteilhafte Vorrichtungen zum Durchfädeln eines Anschlußbändchens durch den Durchbruch einer beidseitig mit isolierenden Klebeschichten versehenen Wandlerplatte an.

Eine erste Ausführungsform einer derartigen Vorrichtung ist gekennzeichnet durch

- einen im Bereich des Durchbruchs auf die Wandlerplatte aufsetzbaren Auflagestempel,
- eine in die Auflagefläche des Auflagestempels eingebrachte und den Durchbruch überquerende Führungsnut für das Anschlußbändchen und
- einen in dem Auflagestempel geführten und durch die Führungsnut und den Durchbruch verschiebbaren Durchziehstempel.

Ein Anschlußbändchen kann dann auf einfache Weise in die Führungsnut des Auflagestempels eingeschoben und durch einen entsprechenden Hub des Durchziehstempels durch den Durchbruch der Wandlerplatte gefädelt werden.

Eine zweite Ausführungsform einer derartigen Vorrichtung ist gekennzeichnet durch

- einen im Bereich des Durchbruchs auf die Wandlerplatte aufsetzbaren Auflagestempel und
- eine in die Auflagefläche des Auflagestempels eingebrachte und kurvenförmig zum Durchbruch hinführende Führungsnut für das Anschlußbändchen.

Bei dieser zweiten Ausführungsform wird das Anschlußbändchen ebenfalls in die Führungsnut des Auflagestempels eingeschoben und dabei aber durch den kurvenförmigen Verlauf direkt in den Durchbruch gelenkt. Dabei ist es zweckmäßig, wenn zusätzlich ein im Bereich des Durchbruchs gegen die andere Seite der Wandlerplatte drückbarer Gegenstempel vorgesehen ist, in dessen Auflagefläche eine von dem Durchbruch kurvenförmig zur Wandlerplatte zurückführende weitere Führungsnut für das Anschlußbändchen eingebracht ist.

Bei beiden Ausführungsformen der Vorrichtung ist es besonders günstig, wenn das Anschlußbändchen mittels einer Vorschubeinrichtung in die Führungsnut des Auflagestempels einführbar ist.

Gemäß einer weiteren Ausgestaltung der erfindungsgemäßen Vorrichtungen ist mit dem Abheben des Auflagestempels von der Wandlerplatte eine Schneideinrichtung zum Abtrennen des Anschlußbändchens auslösbar.

Weiterhin hat es sich für einen rationellen Fertigungsablauf als besonders günstig herausgestellt, wenn die beidseitig mit isolierenden Klebeschichten versehene Wandlerplatte in der Aufnahme eines Rundschalttellers positionierbar ist und in die Oberseite von Aufnahme und Rundschaltteller zur Führungsnut des Auflagestempels fluchtend ausgerichtete Nuten eingebracht sind. Während des Einfädelvorganges können dann gleichzeitig an weiteren Stationen eines entsprechenden Rundschalttisches andere für die Herstellung der Wandlerplatte erforderliche Arbeitsgänge durchgeführt werden.

Ausführungsbeispiele einer erfindungsgemäßen Wandlerplatte und von Vorrichtungen zum Durchfädeln eines Anschlußbändchens sind in der Zeichnung dargestellt und werden im folgenden näher beschrieben.

Es zeigen:

Figur 1 eine Wandlerplatte für piezoelektrische Wandler mit einem durch einen Durchbruch hindurchgeführten Anschlußbändchen,

Figur 2 ein erstes Ausführungsbeispiel einer Vorrichtung zum Druchfädeln eines Anschlußbändchens durch den Durchbruch der in Figur 1 dargestellten Wandlerplatte und

Figur 3 ein zweites Ausführungsbeispiel einer Vorrichtung zum Durchfädeln eines Anschlußbändchens durch den Durchbruch der in Figur 1 dargestellten Wandlerplatte.

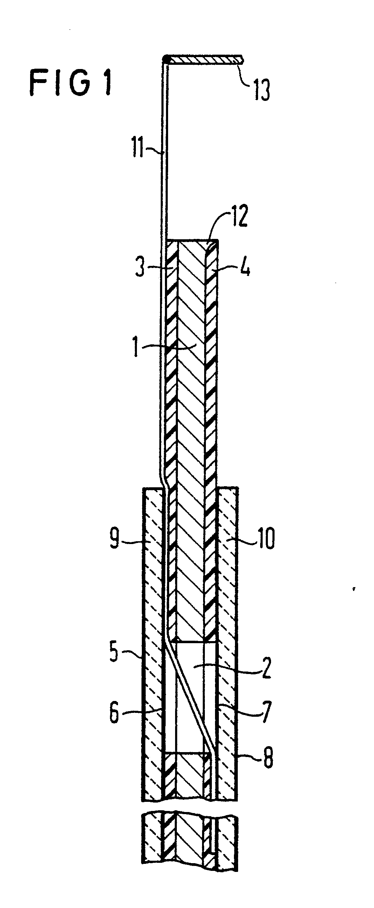

Gemäß Figur 1 ist in eine beispielsweise aus Aluminium bestehende Wandlerplatte 1, die nachfolgend als Membran bezeichnet werden soll, ein Durchbruch 2 eingebracht. Auf beiden Seiten der Membran 1 ist ganzflächig eine isolierende Klebeschicht 3, 4 vorgesehen. Die isolierenden Klebeschichten 3 und 4 sind beispielsweise 60 $\mu$m ± 10 $\mu$m dick, wobei als Material ein thermoplastischer Kleber, wie z.B. ein Polyäthylen-Acrylsäure-Copolymerisat verwendet wird. Die beidseitig mit Elektroden 5, 6, 7, 8 versehenen Piezokeramiken 9, 10 sind durch einen Preßvorgang unter gleichzeitiger Einwirkung von Wärme mit der Klebeschicht 3, 4 verbunden. Bei den Elektroden 5, 6, 7, 8 handelt es sich beispielsweise um dünne Schichten aus in die Piezokeramik 9, 10 eingebranntem Silber. Die äußeren Elektroden 5 und 8 werden mit Hilfe von in der Zeichnung nicht näher dargestellten Anschlußbändchen aus Kupfer mittels Lötung kontaktiert. Die inneren Elektroden 6 und 7 werden derart kontaktiert, daß vor dem Preßvorgang zum Aufkleben der Piezokeramiken 9 und 10 ein Anschlußbändchen 11 aus Kupfer auf einer Seite zwischen die innere Elektrode 7 und die Klebeschicht 4 angelegt wird, durch den Durchbruch 2 hindurchgeführt wird und auf der anderen Seite zwischen der Klebeschicht 3 und der inneren Elektrode 6 nach außen geführt wird. Beim Preßvorgang zum Aufkleben der Piezokeramiken 9 und 10 wird dann das Anschlußbändchen 11 mit den beiden klebstoffseitigen inneren Elektroden 6 und 7 druckkontaktiert.

Die Vorteile der beschriebenen Anordnung liegen in der einfachen Herstellung der beiden Druckkontakte, wobei insbesondere die Automatisierbarkeit dieses Vorgangs hervorzuheben ist. Außerdem braucht für die Kontaktierung der beiden klebstoffseitigen Elektroden 6 und 7 nur noch ein einziges Anschlußbändchen 11 zugeführt zu werden. Das Anschlußbändchen 11 wird auf derjenigen Seite der mit den Klebeschichten 3 und 4 versehenen Membran 1 nach außen geführt, die dem beim Stanzen der kreisförmigen Membran 1 entstandenen Stanzgrat 12 gegenüberliegt. Die Gefahr eines Kurzschlusses zwischen dem Anschlußbändchen 11 und dem Stanzgrad 12 der Membran 1 wird hierdurch ausgeschlossen. Das äußere Ende des Anschlußbändchens 11 wird mit einem weiterführenden Bauteil 13 elektrisch leitend verbunden. Bei dem weiterführenden Bauteil 13 handelt es sich beispielsweise um eine Lötfahne.

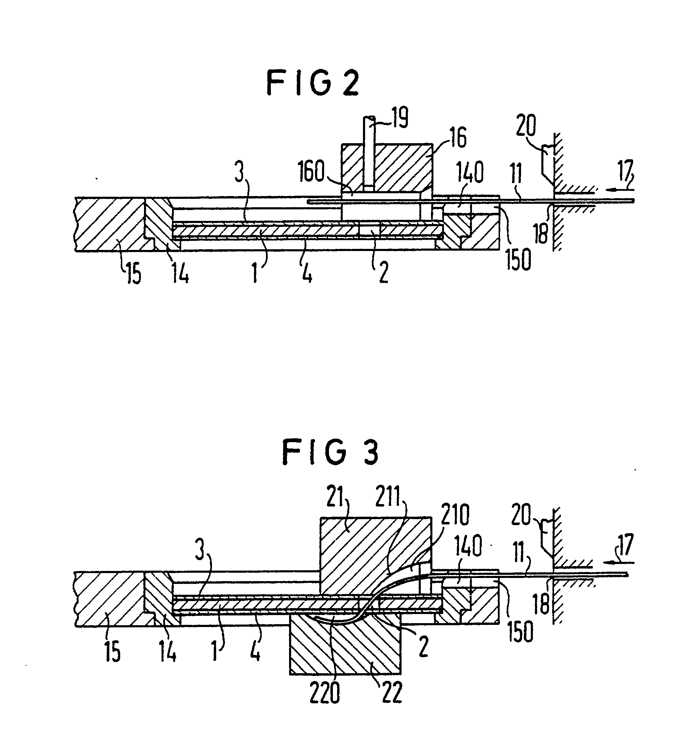

Figur 2 zeigt eine erste Vorrichtung zum Durchfädeln eines Anschlußbändchens 11 durch den Durchbruch 2 der beidseitig mit isolierenden Klebeschichten 3 und 4 versehenen Membran 1. Die Membran 1 wird hierbei in der Aufnahme 14 eines Rundschalttellers 15 positioniert.

Über dem Bereich des Durchbruchs 2 der Membran 1 befindet sich ein Auflagestempel 16, in dessen untere Auflagefläche eine Führungsnut 160 eingebracht ist. Wird nun der Auflagestempel 16 durch einen entsprechenden Abwärtshub auf die Klebeschicht 3 der Membran 1 aufgesetzt, so entsteht durch die Führungsnut 160 und fluchtend dazu in die Aufnahme 14 und den Rundschaltteller 15 eingebrachten Nuten 140 bzw. 150 ein fast durchgehender Führungskanal, der nur wenig breiter als das Anschlußbändchen 11 ist. Mittels einer nur durch den Pfeil 17 angedeuteten Vorschubeinrichtung wird dann das Anschlußbändchen 11 durch eine Öffnung 18 so weit in die Nuten 150 und 140 und die Führungsnut 160 geschoben, daß es den Durchbruch 2 überquert. Danach wird ein in dem Auflagestempel 160 geführter, kreiszylindrischer Durchziehstempel 19 abwärts bewegt, wobei das Anschlußbändchen 11 durch den Durchbruch 2 gefädelt wird. Der Hub des Durchziehstempels 19 ist dabei so bemessen, daß das innere Ende des Anschlußbändchens 11 aufspringt und sich an die untere Klebeschicht 4 der Membran 1 anlegt. Gleichzeitig mit dem Rückwärtshub des Durchziehstempels 19 und des Auflagestempels 16 wird das Anschlußbändchen 11 durch eine Schneideeinrichtung 20 auf die erforderliche Länge geschnitten.

Figur 3 zeigt eine zweite Vorrichtung zum Durchfädeln eines Anschlußbändchens 11 durch den Durchbruch 2 der beidseitig mit isolierenden Klebeschichten 3 und 4 versehenen Membran 1. Auch hier wird die Membran 1 wieder in der Aufnahme 14 eines Rundschaltteller 15 positioniert.

Über dem Bereich des Durchbruchs 2 der Membran 1 befindet sich ein Auflagestempel 21, in dessen untere Auflagefläche eine kurvenförmig nach unten führende Führungsnut 210 eingebracht ist. Wird nun der Auflagestempel 21 durch einen entsprechenden Abwärtshub auf die Klebeschicht 3 der Membran 1 aufgesetzt, so entsteht durch die Nuten 150 und 140 und die Führungsnut 210 ein fast durchgehender Führungskanal, der nur wenig breiter als das Anschlußbändchen 11 ist. Mittels der durch den Pfeil 17 angedeuteten Vorschubeinrichtung wird dann das Anschlußbändchen 11 durch die Öffnung 18 in die Nuten 150 und 140 und in die Führungsnut 210 geschoben. Hierbei wird das Anschlußbändchen 11 durch den kurvenförmigen, polierten Nutgrund 211 der Führungsnut 210 direkt in den Durchbruch 2 der Membran 1 gelenkt. Unterhalb der Membran 1 ist im Bereich des Durchbruchs 2 ein Gegenstempel 22 gegen die untere Klebeschicht 4 angelegt. In die Auflagefläche dieses Gegenstempels 22 ist eine von dem Durchbruch 2 kurvenförmig wieder zur Klebeschicht 4 zurückführende weitere Führungsnut 220 eingebracht, welche das innere Ende des Anschlußbändchens 11 in entsprechender Weise an die Unterseite umlenkt. Gleichzeitig mit dem Rückwärtshub des Auflagestempels 21 und des Gegenstempels 22 wird das Anschlußbändchen 11 dann wieder durch die Schneideinrichtung 20 auf die erforderliche Länge geschnitten.

Der Gegenstempel 22 kann auch starr angeordnet werden, d.h. er braucht keine Hubbewegung auszuführen, wenn der Rundschaltteller 15 vor bzw. nach seiner Drehbewegung einen Vertikalhub ausführt. Bei günstigen Verhältnissen von Breite des Anschlußbändchens 11, Dicke der Membran 1, Durchmesser des Durchbruchs 2 und Elastizität des Anschlußbändchens 11 kann der Gegenstempel 22 ganz entfallen.

Die in Figur 3 dargestellte Vorrichtung ist für eine rationelle und automatisierte Fertigung besonders gut geeignet. Gegenüber der in Figur 2 dargestellten Vorrichtung ergibt sich insbesondere der Vorteil, daß der Durchziehstempel 19 nicht benötigt wird und damit eine Funktion weniger ausgeführt werden muß.

## Ansprüche

1. Wandlerplatte (1) mit piezoelektrischen Wandlern, insbesondere für Fernhörer in Fernsprechanlagen, welche aus elektrisch leitfähigem Material besteht und auf deren beide Seiten jeweils eine beidseitig mit Elektroden (5, 6, 7, 8) versehene Piezokeramik (9, 10) mittels einer elektrisch isolierenden Klebeschicht (3, 4) aufgebracht ist, wobei beide Piezokeramiken (3, 4) elektrisch parallel geschaltet sind, **dadurch gekennzeichnet,** daß die Wandlerplatte (1) mit einem Durchbruch (2) versehen ist, dessen Bereich von den isolierenden Klebeschichten (3, 4) freibleibt und durch welchen ein zwischen Klebeschicht (4) und innerer klebstoffseitiger Elektrode (7) auf einer Seite der Wandlerplatte (1) angeordnetes Anschlußbändchen (11) zur anderen Seite der Wandlerplatte (1) hindurchgeführt ist und dort zwischen Klebeschicht (3) und innerer klebstoffseitiger Elektrode (6) angeordnet ist, wobei das Anschlußbändchen (11) mit den jeweils inneren klebstoffseitigen Elektroden (6, 7) elektrisch verbunden und einseitig nach außen geführt ist.

2. Wandlerplatte nach Anspruch 1, **dadurch gekennzeichnet,** daß die beiden beidseitig mit Elektroden (5, 6 und 7, 8) versehenen Piezokeramiken (9, 10) einander gegenüberliegend auf der Wandlerplatte (1) angeordnet sind und daß der Durchbruch (2) im Bereich der Piezokeramiken (9, 10) in die Wandlerplatte (1) eingebracht ist.

3. Wandlerplatte nach Anspruch 1 oder 2, **dadurch gekennzeichnet,** daß das Anschlußbändchen (11) auf der dem Stanzgrat (12) der Wandlerplatte (1) gegenüberliegenden Seite nach außen geführt ist.

4. Vorrichtung, mit der ein Anschlußbändchen durch den Durchbruch einer beidseitig mit isolierenden Klebeschichten versehenen Wandlerplatte nach einem der Ansprüche 1 bis 3 durchgefädelt wird, **gekennzeichnet** durch
   - einen im Bereich des Durchbruchs (2) auf die Wandlerplatte (1) aufsetzbaren Auflagestempel (16),
   - eine in die Auflagefläche des Auflagestempels (16) eingebrachte und den Durchbruch (2) überquerende Führungsnut (160) für das Anschlußbändchen (11) und
   - einen in dem Auflagestempel (16) geführten und durch die Führungsnut (160) und den Durchbruch (2) verschiebbaren Durchziehstempel (19).

5. Vorrichtung, mit der ein Anschlußbändchen durch den Durchbruch einer beidseitig mit isolierenden Klebeschichten versehenen Wandlerplatte nach einem der Ansprüche 1 bis 3 durchgefädelt wird, **gekennzeichnet** durch
   - einen im Bereich des Durchbruchs (2) auf die Wandlerplatte (1) aufsetzbaren Auflagestempel (21) und
   - eine in die Auflagefläche des Auflagestempels (21) eingebrachte und kurvenförmig zum Durchbruch (2) hinführende Führungsnut (210) für das Anschlußbändchen (11).

6. Vorrichtung nach Anspruch 5, dadurch **gekennzeichnet,** daß zusätzlich ein im Bereich des Durchbruchs (2) gegen die andere Seite der Wandlerplatte (1) drückbarer Gegenstempel (22) vorgesehen ist, in dessen Auflagefläche eine von dem Durchbruch (2) kurvenförmig zur Wandlerplatte (1) zurückführende weitere Führungsnut (220) für das Anschlußbändchen (11) eingebracht ist.

7. Vorrichtung nach einem der Ansprüche 4 bis 6, dadurch **gekennzeichnet,** daß das Anschlußbändchen (11) mittels einer Vorschubeinrichtung (17) in die Führungsnut (160; 220) des Auflagestempels (16; 22) einführbar ist.

8. Vorrichtung nach einem der Ansprüche 4 bis 7, dadurch **gekennzeichnet,** daß mit dem Abheben das Auflagestempels (16 ; 22) von der Wandlerplatte (1) eine Schneideinrichtung (20) zum Abtrennen des Anschlußbändchens (11) auslösbar ist.

9. Vorrichtung nach einem der Ansprüche 4 bis 8, dadurch **gekennzeichnet,** daß die beidseitig mit isolierenden Klebeschichten (3, 4) versehene Wandlerplatte (1) in der Aufnahme (14) eines Rundschalttellers (15) positionierbar ist und daß in die Oberseite von Aufnahme (14) und Rundschaltteller (15) zur Führungsnut (160; 220) des Auflagestempels (16; 22) fluchtend ausgerichtete Nuten (140, 150) eingebracht sind.

**Claims**

1. A transducer plate (1) with piezoelectric transducers, preferably for telephone receivers in telephone systems, which consists of electrically conductive material and on the two sides of which in each case a piezoceramic (9, 10) provided on both sides with electrodes (5, 6, 7, 8) is supplied by means of an electrically insulating adhesive layer (3, 4), both piezoceramics (3, 4) being electrically connected in parallel, characterised in that the transducer plate (1) is provided with a passage (2), the region of which remains free of the insulating adhesive layer (3, 4) and through which a connector ribbon (11) arranged on one side of the transducer plate (1) between adhesive layer (4) and inner electrode (7) on the adhesive side is fed through to the other side of the transducer plate (1) and is arranged there between adhesive layer (3) and inner electrode (6) on the adhesive side, the connector ribbon (11) being electrically connected to the respective inner electrodes (6, 7) on the adhesive side and being presented externally on one side.

2. Transducer plate according to Claim 1, characterised in that the two piezoceramics (9, 10) provided on both sides with electrodes (5, 6 and 7, 8) are arranged opposite one another on the transducer plate (1) and in that the passage (2) is made in the transducer plate (1) in the region of the piezoceramics (9, 10).

3. Transducer plate according to Claim 1 or 2, characterised in that the connector ribbon (11) on the side opposite the burr (12) of the transducer plate (1) is presented externally.

4. Device with which a connector ribbon is threaded, according to one of Claims 1 to 3, through the passage of a transducer plate provided on both sides with insulating adhesive layers, characterised by
   - a bed die (16) which can be placed on the transducer plate (1) in the region of the passage (2)
   - a guide channel (160), for the connector ribbon (11), which is introduced into the bearing surface of the bed die (16) and traverses the passage (2) and
   - a hob extruding punch (19) which is guided in the bed die (16) and can be moved through the guide channel (160) and the passage (2).

5. Device with which a connector ribbon can be threaded, according to one of Claims 1 to 3, through the passage of a transducer plate provided on both sides with insulating adhesive layers, characterised by
   - a bed die (21) which can be placed on the transducer plate (1) in the region of the passage (2) and
   - a guide channel (210) for the connector ribbon (11), which is introduced into the bearing surface of the bed die (21) and leads in a curved manner to the passage (2).

6. Device according to Claim 5, characterised in that in addition a cooperating die (22) which can be pressed against the other side of the transducer plate (1) is provided in the region of the passage (2), in the bearing surface of which cooperating die there is a further guide channel (220) for the connector ribbon (11), which leads back from the passage (2) in a curved manner to the transducer plate (1).

7. Device according to one of Claims 4 to 6, characterised in that the connector ribbon (11) can be introduced into the guide channel (160; 220) of the bed die (16; 22) by means of a feed apparatus (17).

8. Device according to one of Claims 4 to 7, characterised in that a cutting device (20) for cutting the connector ribbon (11) can be triggered when the bed die (16; 22) lifts off from the transducer plate (1).

9. Device according to one of Claims 4 to 8, characterised in that the transducer plate (1) provided on both sides with insulating adhesive layers (3, 4) can be positioned in the receptacle (14) of a rotary indexing table (15) and in that there are grooves (140, 150) aligned flush with the guide channel (160; 220) of the bed die (16; 22) in the upper side of the receptacle (14) and the rotary indexing table (15).

**Revendications**

1. Plaque (1) pour transducteurs piézoélectriques, notamment pour des écouteurs dans des installations téléphoniques, qui est constituée par un matériau électriquement conducteur et sur les deux faces de laquelle respectivement une piézocéramique (9,10) pourvue d'électrodes (5,6,7,8) sur ses deux faces est fixée à l'aide d'une couche de colle électriquement isolante (3,4), les deux piézocéramiques (3,4) étant branchées électriquement en parallèle, caractérisée par le fait que la plaque (1) pour transducteurs comporte une ouverture (2), dans laquelle ne subsiste aucune couche de colle isolante (3,4) et que traverse une bandelette de raccordement (11) disposée entre la couche de colle (4) et une électrode intérieure (7), située du côté de la colle, sur une face de la plaque (1) équipée de transducteurs, en direction de l'autre face de cette plaque, et disposée, à cet endroit, entre la couche de colle (3) et l'électrode intérieure (6) située du côté de la colle, la bandelette de raccordement (11) étant raccordée électriquement aux électrodes intérieures respectives (6,7) situées du côté de la colle et ressortant d'un côté.

2. Plaque pour transducteurs suivant la revendication 1, caractérisée par le fait que les deux piézocéramiques (9,10), comportant des électrodes (5, 6 et 7, 8) sur leurs deux faces, sont disposées en vis-à-vis l'une de l'autre sur la plaque (1) équipée de transducteurs et que l'ouverture (2) est ménagée dans la plaque (1) équipée de transducteurs, dans la zone des piézocéramiques (9,10).

3. Plaque pour transducteurs selon la revendication 1 ou 2, caractérisée en ce que la bandelette de raccordement (11) ressort sur le côté tourné à l'opposé de la bavure de découpage (12) de la plaque (1) équipée de transducteurs.

4. Dispositif, à l'aide duquel la bandelette de raccordement est enfilée dans l'ouverture d'une plaquette pour transducteurs, pourvue sur ses deux faces de colle isolantes, suivant l'une des revendications 1 à 3, caractérisé par
   - un poinçon d'application (16), pouvant être appliqué sur la plaque (1) pour transducteurs, dans la zone de l'ouverture (2),

- une rainure de guidage (160) prévue pour la bandelette de raccordement (11) et ménagée dans la surface d'application du poinçon d'application (16) et s'étendant en travers de l'ouverture (2), et
- un poinçon d'enfilage (19) guidé dans le poinçon d'application (16) et pouvant être déplacé dans la rainure de guidage (160) et l'ouverture (2).

5. Dispositif, permettant d'enfiler une bandelette de raccordement dans l'ouverture d'une plaque pour transducteurs et comportant, sur ses deux faces, des couches de colle isolantes, suivant l'une des revendications 1 à 3, caractérisé par
- un poinçon d'application (21) pouvant être posé sur la plaque (1) équipée de transducteurs, dans la zone de l'ouverture (2), et
- une rainure de guidage (210) prévue pour la bandelette de raccordement (11) et ménagée dans la surface d'application du poinçon d'application (21) et pénétrant avec une forme courbe en direction de l'ouverture (2).

6. Dispositif suivant la revendication 5, caractérisé par le fait qu'il est en outre prévu un poinçon antagoniste (22), qui peut être repoussé, dans la zone de l'ouverture (2), contre l'autre face de la plaque (1) pour transducteurs et dans la surface d'application duquel est ménagée une autre rainure de guidage (220) prévue pour la bandelette de raccordement (11) et retournant avec une forme courbe, de l'ouverture (2) vers la plaque (1) pour transducteurs.

7. Dispositif suivant l'une des revendications 4 à 6, caractérisé par le fait que la bandelette de raccordement (11) peut être introduite à l'aide d'un dispositif d'avance (17) dans la rainure de guidage (160;220) du poinçon d'application (16;22).

8. Dispositif suivant l'une des revendications 4 à 7, caractérisé par le fait qu'un dispositif de découpage (20) servant à sectionner la bandelette de raccordement (11) est peut être déclenché lors du soulèvement du poinçon d'application (16;22) à partir de la plaque (1) pour transducteurs.

9. Dispositif suivant l'une des revendications 4 à 8, caractérisé par le fait que la plaque (1) pour transducteurs, qui porte des couches de colle isolantes (3,4) sur ses deux faces, peut être positionnée dans le logement (14) d'une table de transfert circulaire (15) et que des rainures (140,150) alignées avec la rainure de guidage (160;220) du poinçon d'application (16;22) sont ménagées dans la face supérieure du logement (14) et de la table de transfert circulaire (15).

FIG 1

# FIG 2

# FIG 3